# EUROPEAN PATENT SPECIFICATION

(11) **EP 2 975 413 B1**
(45) Date of publication and mention of the grant of the patent: **08.03.2017**
(21) Application number: 14177078.4
(22) Date of filing: 15.07.2014
(51) Int. Cl.: G01R 15/06

(54) **Active part of an RC voltage divider**
Aktiver Teil eines RC-Spannungsteilers
Partie active d'un diviseur de tension résistif-capacitif

(43) Date of publication of application: 20.01.2016
(73) Proprietor: Siemens Aktiengesellschaft, 80333 München (DE)
(72) Inventor: Fluri, Rolf, 4057 Basel (CH); Weber, Christian, 4058 Basel (CH)
(74) Representative: Maier, Daniel Oliver

(56) References cited:
- EP-A1- 0 980 003
- US-A1- 2006 012 382

## Description

The invention relates to the technical field of RC voltage dividers.

State of the art is a solution where the whole active part of an RC voltage divider is built into an external housing and filled with oil or in case of a fiber reinforced plastic tube (FRP-tube) alternatively with sulfur hexafluoride (SF₆) gas. The active part of the RC voltage divider may be a stack of several smaller active parts. The external housing usually comprises porcelain or an FRP tube. Documents EP 0 980 003 A1 and US 2006/012382 A1 describe such prior art techniques.

Between the fabrication of the active part stacks and the assembling into the external housing, the active part is exposed to environmental conditions like humidity and dust. Therefore an adequate protection of the active part is necessary. Protection is usually done by means of a plastic bag. It is important to have a clean and dry active part for the assembling.

With the state of the art solution dielectrical testing of the active part with full test voltage is only possible after assembling. In case of a failure the complete unit needs to be disassembled. It is therefore an objective of the present invention to avoid disassembling the entire unit in case a failure occurs during assembling a divider.

This objective is solved by the solutions proposed on the basis of the independent claims. Further advantageous embodiments are proposed by the independent claims.

According to an aspect a method for producing an active part of an RC voltage divider is proposed. In a method step at least two capacitive modules of the active part of the voltage divider are provided. In a further method step each one of the at least two capacitive modules is encapsulated and hermetically sealed. In yet a further method step the at least two encapsulated and hermetically sealed capacitive modules are stacked in order to produce the active part of the RC voltage divider.

According to another aspect an active part for an RC voltage divider is proposed. The active part comprises a stack of at least two individually encapsulated and hermetically sealed capacitive modules.

In the following the invention is described on the basis of embodiments illustrated on the basis of the figures.
Figure 1 shows a block diagram of an active part of an RC voltage divider according to an embodiment of the invention.
Figure 2 shows a block diagram of a voltage divider comprising an active part according to an embodiment of the invention.
Figure 3 shows a flow diagram of a method for producing active parts of RC voltage dividers as described in figures 1 and 2.
Figures 4A and 4B show an RC voltage divider according to an embodiment of the invention.

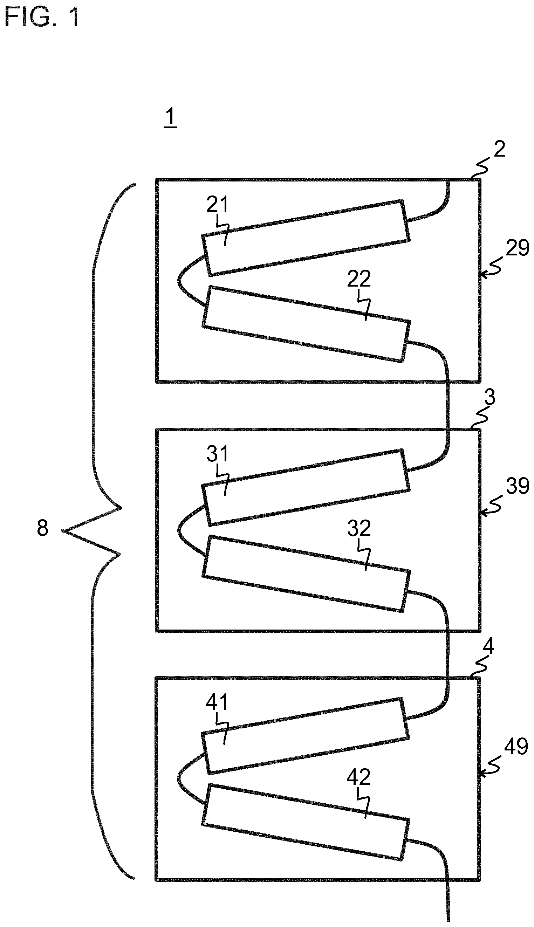

Figure 1 shows an active part 1 for an RC voltage divider comprising a stack 8 of at least two individually encapsulated and hermetically sealed capacitive modules 2, 3, 4 according to an embodiment of the invention. The modules 2, 3, 4 are stacked in such a way that they are connected in series circuit. Each one of the at least two capacitive modules 2, 3, 4 comprises an individual encapsulation 29, 39, 49. Each one of the at least two capacitive modules 2, 3, 4 comprises at least one capacitive element, such as for example capacitors 21, 22, 31, 32, 41, 42. Each one of the at least two capacitive modules 2, 3, 4 is insulated by means of an insulating fluid within the encapsulation 29, 39, 49. The insulating fluid can for example be sulfur hexafluoride or a combination of sulfur hexafluoride and nitrogen gas or oil.

Each of the at least two encapsulated and hermetically sealed capacitive modules 2, 3, 4 comprises minimum dielectrical properties that are testable in a pretest applicable to each of the at least two encapsulated and hermetically sealed capacitive modules 2, 3, 4.

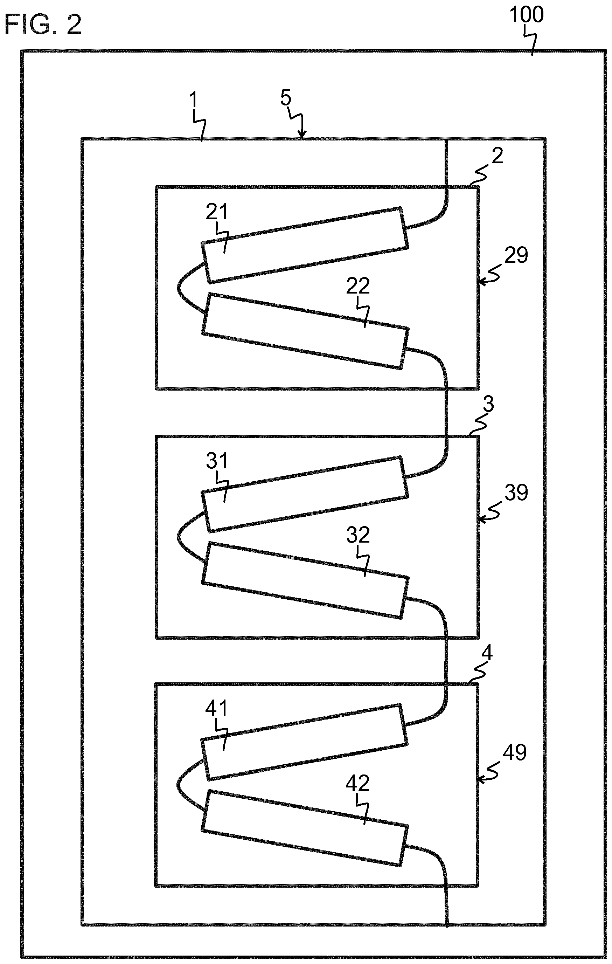

Figure 2 shows an RC voltage divider 100. The RC voltage divider 100 comprises the active part 1 of figure 1 and a hermetically sealed and gas tight housing 5. The housing 5 can be considered to be part of the active part, wherein the at least two encapsulated and hermetically sealed capacitive modules 2, 3, 4 are installed in said housing 5. The housing is preferably an FRP tube. The gas tight housing 5 is filled with a further insulating fluid, such as for example sulfur hexafluoride or a combination of sulfur hexafluoride and nitrogen gas or oil. According to a preferred embodiment the housing is therefore a sealed tube for capacitance elements in SF₆.

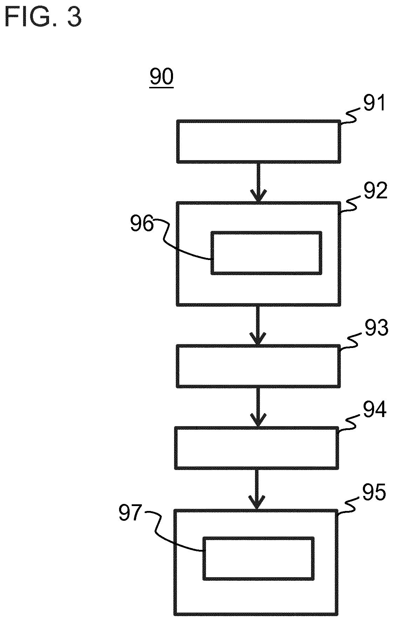

Figure 3 shows a flow diagram of a method 90 according to an embodiment of the invention for producing an active part 1 of an RC voltage divider 100 as described in figures 1 and 2, and also for producing the RC voltage divider. The method 90 comprises method steps 91-97.

In method step 91 capacitive modules 2, 3, 4 of the active part 1 are provided. After that, in method step 92, each one of the capacitive modules 2, 3, 4 is individually encapsulated and hermetically sealed with the encapsulations 29, 39, 49. After that, in method step 94, the encapsulated and hermetically sealed capacitive modules 2, 3, 4 are stacked by interconnecting them in order to produce the active part 1 as e.g. shown in figure 1. The interior of the encapsulated and hermetically sealed capacitive modules 2, 3, 4 is therefore protected from environmental influences such as moisture and dust, e.g. when the capacitive elements are stored prior to assembling the RC voltage divider 100. This reduces the risk of electrical malfunctions and therefore allows avoiding disassembling the entire unit in case a failure occurs during assembling the RC voltage divider 100.

Prior to the method step 94 of stacking the at least two encapsulated and hermetically sealed capacitive modules 2, 3, 4 it is advantageous to perform a method step 93 of pretesting each of the at least two encapsulated and hermetically sealed capacitive modules 2, 3, 4 in order to ensure that the individual modules 2, 3, 4 fulfill quality requirements.

The method step 92 of encapsulating and hermetically sealing each one of the at least two capacitive modules 2, 3, 4 preferably comprises individually insulating 96 each one of the at least two capacitive modules 2, 3, 4. The capacitive modules 2, 3, 4 can be insulated 96 by means of an insulating fluid that is filled into the encapsulation of each of the capacitive modules, such as for example sulfur hexafluoride or a combination of sulfur hexafluoride and nitrogen gas or oil.

According to a preferred embodiment, the method 90 comprises further the method step 95 of installing and hermetically sealing the at least two encapsulated and hermetically sealed capacitive modules 2, 3, 4 in a gas tight housing 5 in order to produce an active part and/or an RC voltage divider as e.g. described on the basis of figure 2.

In order to further insulate the active part 1, the method step 95 further comprises the method step 97 of filling the gas tight housing 5 with a further insulating fluid, such as for example sulfur hexafluoride or a combination of sulfur hexafluoride and nitrogen gas or oil.

In order to increase the quality of the RC voltage divider 100, the housing 5 is dried and evacuated prior to filling the gas tight housing 5 with the further insulating fluid.

Preferably, the insulating fluid in the encapsulations 29, 39, 49 is of the same kind as the further insulating fluid with which the housing 5 is filled. This ensures that in case one of the encapsulations 29, 39, 49 should leak, there will occur no chemical reactions between the insulating fluid originating from within the encapsulations 29, 39, 49 and the further insulating fluid originating from the filling of the housing 5. Thus, this solution prevents changes in the electrical behaviour of the active part 1.

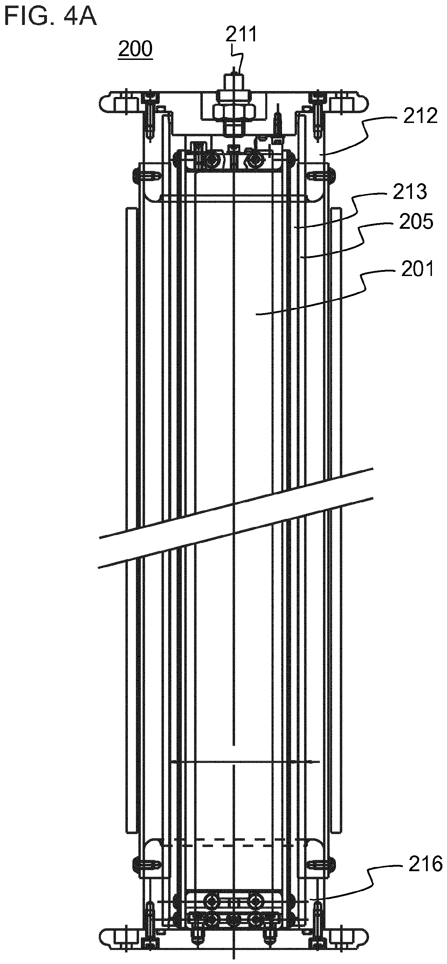

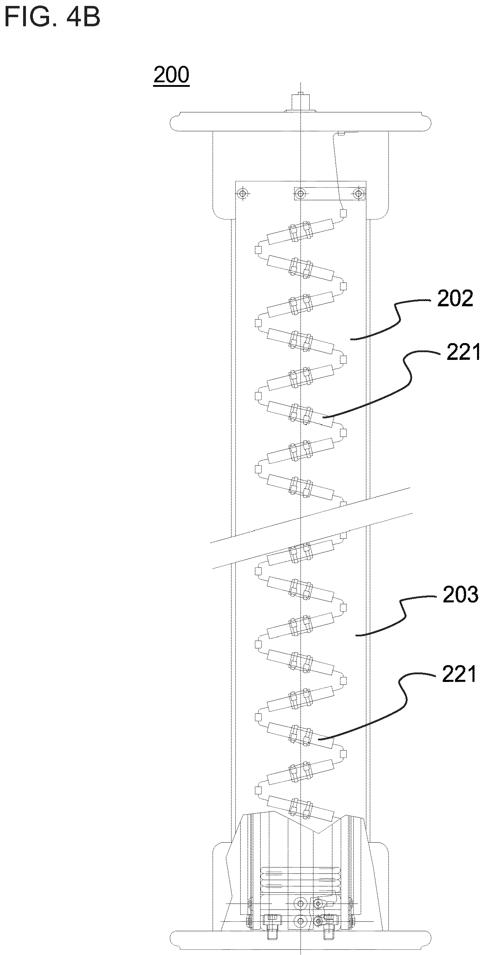

Figures 4A and 4B show schemes of an RC voltage divider 200 according to an embodiment of the invention. Figure 4A focuses mainly on outer parts of the voltage divider 200, while figure 4B focuses on the inside of the voltage divider 200. The voltage divider 200 comprises a gas filling valve 211, an aluminum flange 212, a SF₆ gas compartment 213, an FRP housing 205, and an active part 201, and a second aluminum flange 216. The active part 201 comprises individually encapsulated and hermetically sealed capacitive modules 202, 203. The encapsulated modules comprise capacitive elements 221.

According to a preferred embodiment the active part is installed in a hermetical sealed and gas tight housing (FRP-tube), dried, evacuated and filled with pure SF₆ gas or a combination of SF₆ and Nitrogen gas. Therefore the active part is hermetical sealed and encapsulated from the gas insulated switchgear (GIS) gas compartment.

Compared to isolating oil, solutions based on SF₆ or some other gas are significantly lighter in weight. Moreover, solutions based on SF₆ are less inflammable than solutions based on oil. However, handling with SF6 needs strict clean room conditions and an advanced production process. Therefore the use of SF₆ as an insulating media is more expensive. Due to the modularisation these disadvantages will be partly compensated in preferred embodiments and a SF₆ solution becomes more cost-effective. An encapsulated gas insulated solution is less sensitive to environmental influences and can be pre-tested with the full rated test voltage. Once tested, an encapsulated and hermetically sealed capacitive module is a unit that can be handled and stored easily and safe. The separate units may be stacked together to bigger units such as active parts. An RC voltage divider can comprise more than one bigger unit or active part.

An embodiment of the invention allows to have a complete oil free RC voltage divider. Furthermore, it becomes possible to pre-assemble the active part stacks (capacitor stacks) under clean-room conditions. Moreover, an embodiment of the invention allows to have the possibility to test active part modules before assembling them and to put together several active part modules to bigger units. Small modules can be tested with lower test voltage.

## Claims

1. Method (90) for producing an active part (1, 201) of an RC voltage divider (100, 200), comprising the steps of
- providing (91) at least two capacitive modules (2, 3, 4, 202, 203) of the active part (1, 201) of the RC voltage divider (100, 200);
- individually encapsulating and hermetically sealing (92) each one of the at least two capacitive modules (2, 3, 4, 202, 203) with individual encapsulations (29, 39, 49);
- stacking (94) the at least two encapsulated and hermetically sealed capacitive modules (2, 3, 4, 202, 203) in order to produce the active part (1, 201) of the RC voltage divider (100, 200).

2. The method (90) of claim 1, wherein the method step (92) of encapsulating and hermetically sealing each one of the at least two capacitive modules (2, 3, 4, 202, 203) comprises insulating (96) each one of the at least two capacitive modules (2, 3, 4, 202, 203).

3. The method (90) of any one of the preceding claims, wherein each one of the at least two capacitive modules (2, 3, 4, 202, 203) is insulated (96) by means of an insulating fluid, such as for example sulfur hexafluoride or a combination of sulfur hexafluoride and nitrogen gas or oil.

4. The method (90) of any one of the preceding claims, comprising a method step (93) of pretesting each of the at least two encapsulated and hermetically sealed capacitive modules (2, 3, 4, 202, 203) prior to the method step (94) of stacking the at least two encapsulated and hermetically sealed capacitive modules (2, 3, 4, 202, 203).

5. The method (90) of any one of the preceding claims, comprising a method step (95) of installing and hermetically sealing the at least two encapsulated and hermetically sealed capacitive modules (2, 3, 4, 202, 203) in a gas tight housing (5, 205).

6. The method (90) of claim 5, wherein the method step (95) of installing and hermetically sealing the at least two encapsulated and hermetically sealed capacitive modules (2, 3, 4, 202, 203) in a gas tight housing (5, 205) comprises the method step (97) of filling the gas tight housing (5, 205) with a further insulating fluid, such as for example sulfur hexafluoride or a combination of sulfur hexafluoride and nitrogen gas or oil.

7. The method (90) of claim 6, wherein prior to filling the gas tight housing (5, 205) with the further insulating fluid, the housing (5, 205) is dried and evacuated.

8. The method of claim 6 or 7, wherein the further insulating fluid is of a same kind as the insulating fluid.

9. Active part (1, 201) for an RC voltage divider (100, 200) comprising a stack (8) of at least two individually encapsulated and hermetically sealed capacitive modules (2, 3, 4, 202, 203) with individual encapsulations (29, 39, 49).

10. The active part (1, 201) of claim 9, wherein each one of the at least two capacitive modules (2, 3, 4, 202, 203) comprises an individual encapsulation (29, 39, 49), wherein each one of the at least two capacitive modules (2, 3, 4, 202, 203) is insulated by means of an insulating fluid within the encapsulation.

11. The active part (1, 201) of claim 10, wherein the insulating fluid comprises sulfur hexafluoride or a combination of sulfur hexafluoride and nitrogen gas or oil.

12. The active part (1, 201) of any one of claims 9 to 11 comprising a hermetically sealed and gas tight housing (5, 205), wherein the at least two encapsulated and hermetically sealed capacitive modules (2, 3, 4, 202, 203) are installed in said housing (5, 205).

13. The active part (1, 201) of claim 12, wherein the gas tight housing (5, 205) is filled with a further insulating fluid, such as for example sulfur hexafluoride or a combination of sulfur hexafluoride and nitrogen gas or oil.

14. The active part (1, 201) of any one of claims 9 to 13, wherein each of the at least two encapsulated and hermetically sealed capacitive modules (2, 3, 4, 202, 203) comprises minimum dielectrical properties that are testable in a pretest applicable each of the at least two encapsulated and hermetically sealed capacitive modules (2, 3, 4, 202, 203).

15. The active part (1, 201) of any one of claims 13 or 14, wherein the further insulating fluid is of a same kind as the insulating fluid.

## Patentansprüche

1. Verfahren (90) zum Herstellen eines aktiven Teils (1, 201) eines RC-Spannungsteilers (100, 200), welches die folgenden Schritte umfasst:
- Bereitstellen (91) von wenigstens zwei kapazitiven Modulen (2, 3, 4, 202, 203) des aktiven Teils (1, 201) des RC-Spannungsteilers (100, 200);
- separates Einkapseln und hermetisches Abdichten (92) jedes der wenigstens zwei kapazitiven Module (2, 3, 4, 202, 203) mit separaten Einkapselungen (29, 39, 49);
- Stapeln (94) der wenigstens zwei eingekapselten und hermetisch abgedichteten kapazitiven Module (2, 3, 4, 202, 203), um den aktiven Teil (1, 201) des RC-Spannungsteilers (100, 200) herzustellen.

2. Verfahren (90) nach Anspruch 1, wobei der Verfahrensschritt (92) des Einkapselns und hermetischen Abdichtens jedes der wenigstens zwei kapazitiven Module (2, 3, 4, 202, 203) das Isolieren (96) jedes der wenigstens zwei kapazitiven Module (2, 3, 4, 202, 203) umfasst,

3. Verfahren (90) nach einem der vorhergehenden Ansprüche, wobei jedes der wenigstens zwei kapazitiven Module (2, 3, 4, 202, 203) mittels eines Isolierfluids isoliert (96) wird, wie zum Beispiel mittels Schwefelhexafluorid oder einer Kombination von Schwefelhexafluorid und Stickstoffgas oder Öl.

4. Verfahren (90) nach einem der vorhergehenden Ansprüche, welches einen Verfahrensschritt (93) des Vorprüfens jedes der wenigstens zwei eingekapselten und hermetisch abgedichteten kapazitiven Module (2, 3, 4, 202, 203) vor dem Verfahrensschritt (94) des Stapelns der wenigstens zwei eingekapselten und hermetisch abgedichteten kapazitiven Module (2, 3, 4, 202, 203) umfasst.

5. Verfahren (90) nach einem der vorhergehenden Ansprüche, welches einen Verfahrensschritt (95) des Installierens und hermetischen Abdichtens der wenigstens zwei eingekapselten und hermetisch abgedichteten kapazitiven Module (2, 3, 4, 202, 203) in einem gasdichten Gehäuse (5, 205) umfasst.

6. Verfahren (90) nach Anspruch 5, wobei der Verfahrensschritt (95) des Installierens und hermetischen Abdichtens der wenigstens zwei eingekapselten und hermetisch abgedichteten kapazitiven Module (2, 3, 4, 202, 203) in einem gasdichten Gehäuse (5, 205) den Verfahrensschritt (97) des Füllens des gasdichten Gehäuses (5, 205) mit einem weiteren Isolierfluid, wie zum Beispiel Schwefelhexafluorid oder einer Kombination von Schwefelhexafluorid und Stickstoffgas oder Öl, umfasst.

7. Verfahren (90) nach Anspruch 6, wobei vor dem Füllen des gasdichten Gehäuses (5, 205) mit dem weiteren Isolierfluid das Gehäuse (5, 205) getrocknet und evakuiert wird.

8. Verfahren nach Anspruch 6 oder 7, wobei das weitere Isolierfluid von derselben Art wie das Isolierfluid ist.

9. Aktiver Teil (1, 201) für einen RC-Spannungsteiler (100, 200), der einen Stapel (8) von wenigstens zwei separat eingekapselten und hermetisch abgedichteten kapazitiven Modulen (2, 3, 4, 202, 203) mit separaten Einkapselungen (29, 39, 49) umfasst.

10. Aktiver Teil (1, 201) nach Anspruch 9, wobei jedes der wenigstens zwei kapazitiven Module (2, 3, 4, 202, 203) eine separate Einkapselung (29, 39, 49) umfasst, wobei jedes der wenigstens zwei kapazitiven Module (2, 3, 4, 202, 203) mittels eines Isolierfluids innerhalb der Einkapselung isoliert ist.

11. Aktiver Teil (1, 201) nach Anspruch 10, wobei das Isolierfluid Schwefelhexafluorid oder eine Kombination von Schwefelhexafluorid und Stickstoffgas oder Öl umfasst.

12. Aktiver Teil (1, 201) nach einem der Ansprüche 9 bis 11, welcher ein hermetisch abgedichtetes und gasdichtes Gehäuse (5, 205) umfasst, wobei die wenigstens zwei eingekapselten und hermetisch abgedichteten kapazitiven Module (2, 3, 4, 202, 203) in diesem Gehäuse (5, 205) installiert sind.

13. Aktiver Teil (1, 201) nach Anspruch 12, wobei das gasdichte Gehäuse (5, 205) mit einem weiteren Isolierfluid, wie zum Beispiel Schwefelhexafluorid oder einer Kombination von Schwefelhexafluorid und Stickstoffgas oder Öl, gefüllt ist.

14. Aktiver Teil (1, 201) nach einem der Ansprüche 9 bis 13, wobei jedes der wenigstens zwei eingekapselten und hermetisch abgedichteten kapazitiven Module (2, 3, 4, 202, 203) minimale dielektrische Eigenschaften aufweist, welche in einer Vorprüfung prüfbar sind, die für jedes der wenigstens zwei eingekapselten und hermetisch abgedichteten kapazitiven Module (2, 3, 4, 202, 203) anwendbar ist.

15. Aktiver Teil (1, 201) nach einem der Ansprüche 13 oder 14, wobei das weitere Isolierfluid von derselben Art wie das Isolierfluid ist.

## Revendications

1. Un procédé (90) de production d'une partie active (1, 201) d'un diviseur de tension RC (100, 200), comprenant les étapes suivantes :
- la fourniture (91) d'au moins deux modules capacitifs (2, 3, 4, 202, 203) de la partie active (1, 201) du diviseur de tension RC (100, 200);
- l'encapsulage individuel et le scellement hermétique (92) de chacun des au moins deux modules capacitifs (2, 3, 4, 202, 203) avec des encapsulations individuelles (29, 39, 49);
- l'empilement (94) des au moins deux modules capacitifs encapsulés et hermétiquement scellés (2, 3, 4, 202, 203) afin de produire la partie active (1, 201) du diviseur de tension RC (100, 200).

2. Le procédé (90) selon la revendication 1, dans lequel l'étape de procédé (92) d'encapsulation et de scellement hermétique de chacun des au moins deux modules capacitifs (2, 3, 4, 202, 203) comprend l'isolation (96) de chacun des au moins deux modules capacitifs (2, 3, 4, 202, 203).

3. Le procédé (90) selon l'une quelconque des revendications précédentes, dans lequel chacun des au moins deux modules capacitifs (2, 3, 4, 202, 203) est isolé (96) au moyen d'un fluide isolant, tel que par exemple hexafluorure de soufre ou une combinaison d'hexafluorure de soufre et d'azote gazeux ou d'huile.

4. Le procédé (90) selon l'une quelconque des revendications précédentes, comprenant une étape de procédé (93) de prétest de chacun des au moins deux modules capacitifs encapsulés et hermétiquement scellés (2, 3, 4, 202, 203) avant l'étape de procédé (94) d'empilement des au moins deux modules capacitifs encapsulés et hermétiquement scellés (2, 3, 4, 202, 203).

5. Le procédé (90) selon l'une quelconque des revendications précédentes, comprenant une étape de procédé (95) d'installation et de scellement hermétique des au moins deux modules capacitifs encapsulés et hermétiquement scellés (2, 3, 4, 202, 203) dans un logement étanche aux gaz (5, 205).

6. Le procédé (90) selon la revendication 5, dans lequel l'étape de procédé (95) d'installation et de scellement hermétique des au moins deux modules capacitifs encapsulés et hermétiquement scellés (2, 3, 4, 202, 203) dans un logement étanche aux gaz (5, 205) comprend l'étape de procédé (97) de remplissage du logement étanche aux gaz (5, 205) avec un autre fluide isolant, tel que par exemple hexafluorure de soufre ou une combinaison d'hexafluorure de soufre et d'azote gazeux ou d'huile.

7. Le procédé (90) selon la revendication 6, dans lequel avant le remplissage du logement étanche aux gaz (5, 205) avec l'autre fluide isolant, le logement (5, 205) est séché et vidé.

8. Le procédé selon la revendication 6 ou 7, dans lequel l'autre fluide isolant est d'un même type que le fluide isolant.

9. Une partie active (1, 201) pour un diviseur de tension RC (100, 200) comprenant une pile (8) d'au moins deux modules capacitifs individuellement encapsulés et hermétiquement scellés (2, 3, 4, 202, 203) avec des encapsulations individuelles (29, 39, 49).

10. La partie active (1, 201) selon la revendication 9, dans laquelle chacun des au moins deux modules capacitifs (2, 3, 4, 202, 203) comprend une encapsulation individuelle (29, 39, 49), chacun des au moins deux modules capacitifs (2, 3, 4, 202, 203) étant isolé au moyen d'un fluide isolant à l'intérieur de l'encapsulation.

11. La partie active (1, 201) selon la revendication 10, dans laquelle le fluide isolant contient de l'hexafluorure de soufre ou une combinaison d'hexafluorure de soufre et d'azote gazeux ou d'huile.

12. La partie active (1, 201) selon l'une quelconque des revendications 9 à 11 comprenant un logement étanche aux gaz et hermétiquement scellé (5, 205), les au moins deux modules capacitifs encapsulés et hermétiquement scellés (2, 3, 4, 202, 203) étant installés dans ledit logement (5, 205).

13. La partie active (1, 201) selon la revendication 12, dans laquelle le logement étanche aux gaz (5, 205) est rempli avec un autre fluide isolant, tel que par exemple hexafluorure de soufre ou une combinaison d'hexafluorure de soufre et d'azote gazeux ou d'huile.

14. La partie active (1, 201) selon l'une quelconque des revendications 9 à 13, dans laquelle chacun des au moins deux modules capacitifs encapsulés et hermétiquement scellés (2, 3, 4, 202, 203) comprend des propriétés diélectriques minimales qui peuvent être testées au cours d'un prétest applicable à chacun des au moins deux modules capacitifs encapsulés et hermétiquement scellés (2, 3, 4, 202, 203).

15. La partie active (1, 201) selon l'une quelconque des revendications 13 ou 14, dans laquelle l'autre fluide isolant est d'un même type que le fluide isolant.
